# EUROPÄISCHE PATENTSCHRIFT

(11) **EP 3 655 784 B1**
(45) Veröffentlichungstag und Bekanntmachung des Hinweises auf die Patenterteilung: **31.07.2024**
(21) Anmeldenummer: 18800497.2
(22) Anmeldetag: 23.10.2018
(51) Int. Cl.: G01R 15/20

(54) **STROMSENSORANORDNUNG**
CURRENT SENSOR ARRANGEMENT
SYSTÈME DE DÉTECTION DE COURANT

(30) Priorität: 24.10.2017 AT 508922017
(43) Veröffentlichungstag der Anmeldung: 27.05.2020
(73) Patentinhaber: Hirtenberger Automotive Safety GmbH & Co KG, 2552 Hirtenberg (AT); MELECS EWS GmbH, 7011 Siegendorf (AT)
(72) Erfinder: WARENITS, Peter, 2752 Wöllersdorf (AT); HORECKY, Robert, 2000 Stockerau (AT); ZEILER, Gerhard, 1220 Wien (AT)
(74) Vertreter: Maier, Daniel Oliver
(86) Internationale Anmeldenummer: PCT/EP2018/079040
(87) Internationale Veröffentlichungsnummer: WO 2019/081511

(56) Entgegenhaltungen:
- CN-A- 106 653 999
- DE-A1- 102015 117 651
- DE-T2- 69 920 890
- US-A1- 2005 030 004
- US-A1- 2010 301 852
- US-A1- 2014 268 432
- US-A1- 2015 042 324
- US-B2- 8 760 149

## Beschreibung

Die Erfindung bezieht sich auf eine Stromsensoranordnung mit einem Magnetkern und einem Magnetfeldsensor, die in einem Gehäuse angeordnet sind.

In der Fahrzeugelektronik, bei 48 V - Systemen (Hybridfahrzeuge) und Systemen höherer Spannung, besteht die Notwendigkeit, Fehlerströme (Kurzschlussströme oder Überströme) zu detektieren und bei einer entsprechenden Detektion gegebenenfalls eine Stromversorgungseinrichtung auszuschalten. Dabei können große Ausschaltströme im Kiloamperebereich fließen. Die Messung dieser Ströme ist daher teuer und entsprechende Messeinrichtungen erfordern ein großes Bauraumbudget.

Weiterhin sind häufig potentialfreie Messverfahren erforderlich.

Aus dem Stand der Technik ist beispielsweise die DE 10 2015 117 651 A1 bekannt, in der eine Sensorbaugruppe für einen Stromsensor offenbart ist. Es ist ein Magnetkern angeordnet, der eine rechteckige Querschnittform mit abgerundeten Ecken oder eine kreisförmige Querschnittform aufweist. Der Magnetkern ist hohl, d.h. es ist ein Innenraum für eine Stromschiene vorgesehen.

Die Sensorbaugruppe weist weiterhin Hallelemente auf, welche in Aufnahmen gelagert sind. Die Aufnahmen sind wiederum in Schlitzen des Magnetkerns angeordnet.

Weiterhin zeigt die WO 2011/067132 A1 einen pyrotechnischen Sicherungsschalter für eine Batterie eines Fahrzeugs, der einen Gasraum aufweist, in welchem ein Treibsatz, der elektrische Kontakte aufweist, gezündet werden kann. Ein Aufprall des Fahrzeugs wird mittels einer Crashsensorik detektiert und zwischen den Kontakten wird eine Zündspannung gebildet. Der Treibsatz wird gezündet und explodiert, wodurch eine Stromversorgung unterbrochen wird.

Ferner ist in der US 2005/0030004 A1 ein Stromsensor dargestellt, welcher einem U-förmigen Leiter zwischengeordnet ist. Der Stromsensor und der U-förmige Leiter sind in einem Gehäuse aus magnetischem Material angeordnet.

Die US2015/042324A1 offenbart einen Stromsensor in einem Gehäuse, bei welchem Leiter durch rohrförmige Öffnungen in dem Gehäuse sowie durch Ausnehmungen in einem Magnetkern geführt sind. In den Ausnehmungen sind Detektionselemente angeordnet.

Der Erfindung liegt die Aufgabe zugrunde, eine gegenüber dem Stand der Technik weiterentwickelte Stromsensoranordnung anzugeben.

Erfindungsgemäß wird diese Aufgabe gelöst mit einer Stromsensoranordnung der eingangs genannten Art,
bei der ein Zuleiter und ein Ableiter vorgesehen sind,
bei welcher der Zuleiter und der Ableiter mit dem Gehäuse verbunden sind,
bei der zwischen dem Zuleiter und dem Ableiter ein isolierendes Distanzstück anordenbar ist,
bei welcher der Magnetkern einen Innenraum aufweist, durch den der Zuleiter und der Ableiter geführt sind,
bei welcher der Magnetfeldsensor in dem Innenraum des Magnetkerns vorgesehen ist, und
bei welcher der Zuleiter und der Ableiter in einem definierten Abstand zueinander angeordnet sind.

Aufgrund des definierten Abstands zwischen dem Zuleiter und dem Ableiter wird eine definierte Abschwächung eines magnetischen Felds in dem Magnetkern bewirkt, ohne dass dafür z.B. eine Spule nötig ist. Dadurch wird eine kompakte und kostengünstige Ausführung der Stromsensoranordnung erzielt. Durch die Abschwächung des magnetischen Felds wird eine Reduktion einer Flussdichte in der Stromsensoranordnung bewirkt. Dadurch ist es möglich, große Ströme bei kleinen Flussdichten in einem Magnetkreis zu messen.

Es können dadurch weiterhin kostengünstige, weichmagnetische Materialen anstatt spezieller Materialien mit hoher Sättigungsflussdichte für den Magnetkern eingesetzt werden. Darüber hinaus vermeiden kleine magnetische Flussdichten eine remanente Magnetisierung des Magnetkerns, eine Bildung von Remanenzflussdichten und somit Fehler bei der Strommessung.

Ferner wird dadurch, dass der Zuleiter und der Ableiter durch den Innenraum hindurch geführt sind sowie dadurch, dass der Magnetfeldsensor in dem Innenraum des Magnetkerns angeordnet ist, eine vorteilhafte Schirmung und somit eine hohe Messgenauigkeit (d.h. eine Verringerung von Messfehlern) erzielt. Auf separate Schirmungsmaßnahmen, welche insbesondere im Umfeld von Blechen, Fremdfeldern etc. erforderlich sind, kann verzichtet werden.

Die kompakte Ausführung der Stromsensoranordnung, bei welcher der Zuleiter und der Ableiter in dem Innenraum des Magnetkerns geführt sind und der Magnetfeldsensor in dem Innenraum angeordnet ist, ermöglicht einerseits eine Vergrößerung von Strommessbereichen sowie andererseits eine Einsetzbarkeit der Stromsensoranordnung auch bei stark begrenzten Bauraumbudgets.

Es ist günstig, wenn der Magnetfeldsensor zwischen dem Zuleiter und dem Ableiter einerseits und dem Magnetkern andererseits auf jener Seite mit einer Distanz zwischen dem Zuleiter und dem Ableiter einerseits und dem Magnetkern andererseits angeordnet ist.

Durch diese Maßnahme wird eine gezielte Abschwächung des magnetischen Felds und somit eine vorteilhafte Anpassung von zu erfassenden Messgrößen an den verfügbaren Magnetfeldsensor und an Materialeigenschaften des Magnetkerns erzielt.

Eine vorteilhafte Ausgestaltung erhält man, wenn der Magnetkern magnetisch geschlossen ist.

Durch diese Maßnahme wird eine besonders effektive Schirmung erzielt.

Es ist günstig, wenn der Magnetfeldsensor als Förster-Sonde ausgebildet ist.

Durch diese Maßnahme wird eine hohe Messgenauigkeit bewirkt.

Nachfolgend wird die Erfindung anhand von Ausführungsbeispielen näher erläutert.

Es zeigen beispielhaft:
- Fig. 1:: Einen schematischen Aufriss einer beispielhaften Ausführungsvariante einer erfindungsgemäßen Stromsensoranordnung,
- Fig. 2:: Einen schematischen Seitenriss dieser beispielhaften Ausführungsvariante, und
- Fig. 3:: Eine Ergebnisdarstellung einer Finite Elemente - Simulation dieser beispielhaften Ausführungsvariante, wobei ein magnetischer Fluss gezeigt ist.

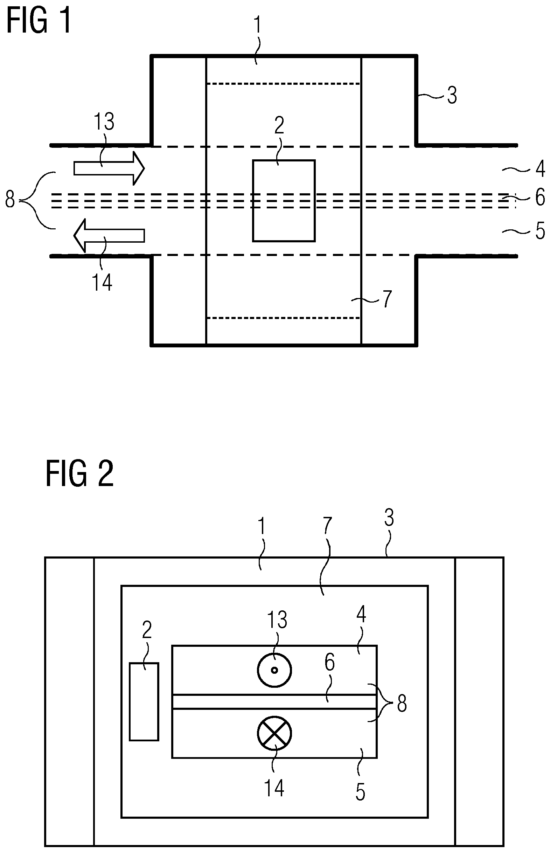

Fig. 1 zeigt eine beispielhafte Ausführungsvariante einer erfindungsgemäßen Stromsensoranordnung als schematischen Aufriss.

Ein Magnetkern 1 aus einem weichmagnetischen Werkstoff (Ferrit) ist in einem Gehäuse 3 aus Kunststoff-Spritzguss angeordnet. Der Magnetkern 1 ist einteilig und somit magnetisch geschlossen ausgeführt, wodurch eine besonders effektive Schirmungswirkung erzielt wird.

Erfindungsgemäß ist es jedoch auch denkbar, dass der Magnetkern 1 mehrere Teile umfasst. Um einen magnetischen Schluss und somit eine günstige Schirmungswirkung auch bei einer mehrteiligen Ausführungsvariante des Magnetkerns 1 zu erreichen, müssen einzelne Teile des Magnetkerns 1 dicht aneinander grenzen.

In dem Gehäuse 3 geführt sind ein Sammelschienenleiter 8 (auch Sammelschiene, Stromschiene oder auf Englisch busbar genannt), der einen Zuleiter 4 und einen Ableiter 5 aufweist, wobei zwischen dem Zuleiter 4 und dem Ableiter 5 ein isolierendes Distanzstück 6 angeordnet ist.

Der Sammelschienenleiter 8 ist einteilig ausgeführt, d.h. er weist eine nicht dargestellte, U-förmige Schleife auf. Der Zuleiter 4 geht demnach ohne Unterbrechung in den Ableiter 5 über.

Erfindungsgemäß ist es auch vorstellbar, den Zuleiter 4 als eigenen ersten Sammelschienenleiter und den Ableiter 5 als eigenen zweiten Sammelschienenleiter getrennt voneinander auszuführen.

Weiterhin ist es auch denkbar, dass das Distanzstück 6 als ein Teil des Gehäuses 3 ausgeführt ist (z.B. als Auskragung, an welcher der Zuleiter 4 und der Ableiter 5 vorbeigeführt sind) und eine isolierende Wirkung zwischen dem Zuleiter 4 und dem Ableiter 5 aufgrund eines Luftspalts zwischen dem Zuleiter 4 und dem Ableiter 5 erreicht wird.

Der Sammelschienenleiter 8 ist in Kupfer ausgeführt und mit einer nicht dargestellten Spannungsversorgungseinheit eines Kraftfahrzeugs verbunden.

Der Magnetkern 1 und der Sammelschienenleiter 8 sind mit dem Gehäuse 3 vergossen.

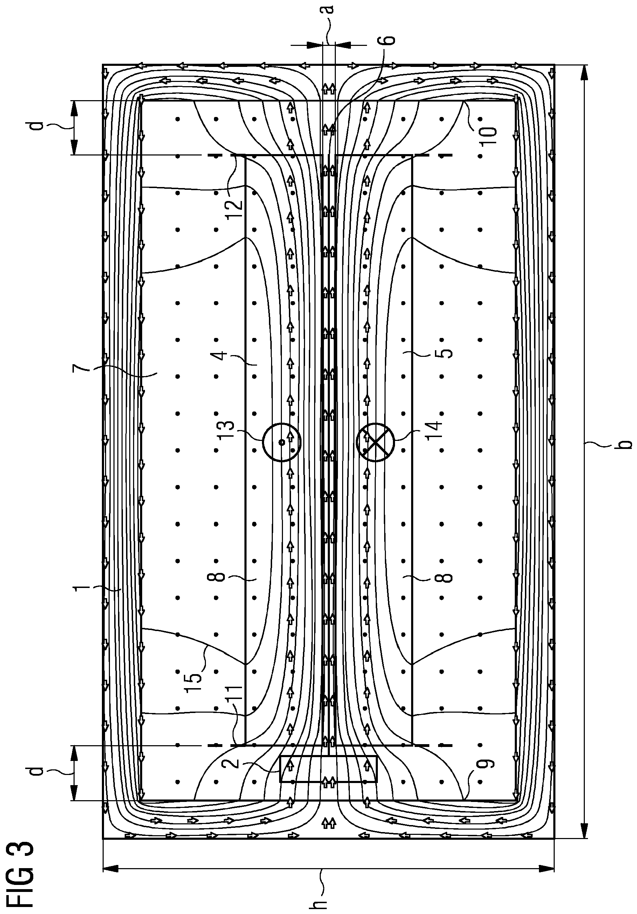

Der Zuleiter 4 und der Ableiter 5 sowie das Distanzstück 6 sind in jenem Bereich, der in Fig. 1 gezeigt ist, parallel zueinander angeordnet und durch den Magnetkern 1, welcher als hohler Quader mit einem Innenraum 7 ausgebildet ist, geführt. Der Zuleiter 4, der Ableiter 5 und das Distanzstück 6 sind in dem Innenraum 7 parallel zu dem Magnetkern 1 angeordnet. Zwischen dem Zuleiter 4 und dem Ableiter 5 ist ein in Fig. 3 gezeigter Abstand a vorgesehen, welcher 0,5 mm beträgt.

Ebenfalls in dem Innenraum 7 des Magnetkerns 1 vorgesehen ist ein aus dem Stand der Technik bekannter, als Hall-Sensor ausgebildeter Magnetfeldsensor 2.

Erfindungsgemäß ist es auch vorstellbar, den Magnetfeldsensor 2 beispielsweise als Superconducting Quantum Interference Device (SQUID) auszuführen. Weiterhin ist als Magnetfeldsensor 2 beispielsweise auch ein Sensor denkbar, welcher auf einem magnetooptischen Effekt basiert, wie z.B. ein polarimetrischer Sensor.

Ferner kann der Magnetfeldsensor 2 auch als aus dem Stand der Technik bekanntes Fluxgate-Magnetometer bzw. als Förster-Sonde ausgebildet sein.

Der Magnetfeldsensor 2 ist, wie in Fig. 3 gezeigt, zwischen einer ersten Seitenwand 9 des Magnetkerns 1 und einer ersten Seitenebene 11 des Zuleiters 4, des Ableiters 5 und des Distanzstücks 6, im Bereich der kleinsten Distanz d zwischen dem Sammelschienenleiter 8 und dem Distanzstück 6 einerseits und dem Magnetkern 1 andererseits angeordnet. Diese Distanz d beträgt 1,5 mm. Da der Sammelschienenleiter 8 und das Distanzstück 6 genau mittig in Bezug auf den Magnetkern 1 angeordnet sind, tritt diese kleinste Distanz d im Ausmaß von 1,5 mm, wie in Fig. 3 ersichtlich, auch zwischen einer zweiten Seitenwand 10 des Magnetkerns 1 und einer zweiten Seitenebene 12 des Sammelschienenleiters 8 und des Distanzstücks 6 auf.

Durch den Sammelschienenleiter 8 hindurch fließt Strom unterschiedlicher Richtungen und mit einer Stromstärke von 3500 A.

Ein erster Stromfluss verläuft, symbolisch dargestellt mittels eines ersten Richtungspfeils 13, nach rechts (bezüglich Fig. 1) durch den Zuleiter 4.

Ein zweiter Stromfluss ist mittels eines zweiten Richtungspfeils 14 symbolisch dargestellt und verläuft nach links (bezüglich Fig. 1) durch den Ableiter 5.

Wegen des ersten Stromflusses und des zweiten Stromflusses bildet sich aufgrund bekannter physikalischer Prinzipien ein magnetischer Fluss aus, welcher in Fig. 3 dargestellt ist. Mittels des Magnetfeldsensors 2 erfolgt eine potentialfreie Messung der Stromstärke des ersten Stromflusses und des zweiten Stromflusses in dem Sammelschienenleiter 8.

In dem Gehäuse 3 ist weiterhin auch ein aus dem Stand der Technik bekannter, pyrotechnischer Trennschalter vorgesehen, der nicht dargestellt ist. Der Trennschalter weist einen Treibsatz, einen ersten Zündkontakt und einen zweiten Zündkontakt auf, welche bei Überschreiten einer definierten Stromstärke (Stör- bzw. Fehlerstrom), welche von einer mit dem Magnetfeldsensor 2 und dem Trennschalter verbundenen, nicht gezeigten Auswerteeinheit detektiert wird, mittels Übertragung entsprechender Zündsignale von dieser Auswerteeinheit an den ersten Zündkontakt und an den zweiten Zündkontakt auslösen und den Treibsatz zünden. Durch eine Explosion wird eine nicht dargestellte elektrische Verbindung in dem Gehäuse 3 unterbrochen, wodurch ein über den Trennschalter mit der Spannungsversorgungseinheit verbundenes, ebenfalls nicht dargestelltes elektrisches Aggregat von der Spannungsversorgungseinheit getrennt wird. Die Stromsensoranordnung fungiert also als Sicherung.

Die von der Spannungsversorgungseinheit bereitgestellte Spannung beträgt 48 V. Erfindungsgemäß sind jedoch auch andere Spannungsbereiche denkbar.

In Fig. 2 ist ein schematischer Seitenriss der in Fig. 1 gezeigten Ausführungsvariante einer erfindungsgemäßen Stromsensoranordnung dargestellt. Es werden daher gleiche Bezugszeichen wie in Fig. 1 verwendet.

Ein erster Stromfluss in einem Zuleiter 4 ist symbolisch mittels eines ersten Richtungspfeils 13, welcher aus einer Bildebene von Fig. 2 heraus zeigt, dargestellt.

Ein zweiter Stromfluss in einem Ableiter 5 ist symbolisch mittels eines zweiten Richtungspfeils 14, welcher in die Bildebene von Fig. 2 hinein zeigt, offenbart.

Fig. 3 offenbart jene Ausführungsvariante einer erfindungsgemäßen Stromsensoranordnung, die auch in Fig. 1 und Fig. 2 dargestellt ist.

Durch einen in einem in Fig. 1 und Fig. 2 gezeigten Gehäuse 3 angeordneten Magnetkern 1, der eine Breite b von 21 mm und eine Höhe h von 12 mm aufweist, hindurch ist ein Sammelschienenleiter 8, welcher einen Zuleiter 4 sowie einen Ableiter 5 aufweist, sowie ein dazwischen angeordnetes isolierendes Distanzstück 6 geführt.

Der Zuleiter 4, der Ableiter 5 und das Distanzstück 6 sind in einem Innenraum 7 des Magnetkerns 1 parallel zueinander und parallel zu dem Magnetkern 1 angeordnet. Zwischen dem Zuleiter 4 und dem Ableiter 5 ist ein Abstand a vorgesehen, welcher 0,5 mm beträgt.

Ebenfalls in dem Innenraum 7 des Magnetkerns 1 vorgesehen ist ein aus dem Stand der Technik bekannter Magnetfeldsensor 2. Er ist zwischen einer ersten Seitenwand 9 des Magnetkerns 1 und einer ersten Seitenebene 11 des Sammelschienenleiters 8 und des Distanzstücks 6, im Bereich der kleinsten Distanz d zwischen dem Sammelschienenleiter 8 und dem Distanzstück 6 einerseits und dem Magnetkern 1 andererseits angeordnet.

Diese Distanz d beträgt 1,5 mm. Da der Sammelschienenleiter 8 und das Distanzstück 6 genau mittig in Bezug auf den Magnetkern 1 angeordnet sind, tritt diese kleinste Distanz d im Ausmaß von 1,5 mm auch zwischen einer zweiten Seitenwand 10 des Magnetkerns 1 und einer zweiten Seitenebene 12 des Sammelschienenleiters 8 und des Distanzstücks 6 auf. Erfindungsgemäß sind jedoch auch andere, außermittige Anordnungen des Sammelschienenleiters 8 und des Distanzstücks 6 denkbar.

Weiterhin ist es auch denkbar, dass zwischen dem Zuleiter 4 und dem Ableiter 5 anstatt des Distanzstücks 6 ein Luftspalt von definierter Größe vorgesehen ist. Entscheidend ist ein Vorhandensein isolierender Eigenschaften zwischen dem Zuleiter 4 und dem Ableiter 5.

Durch den Sammelschienenleiter 8 hindurch fließt Strom unterschiedlicher Richtungen (erster Stromfluss in dem Zuleiter 4 mit einem symbolischen ersten Richtungspfeil 13, zweiter Stromfluss in dem Ableiter 5 mit einem symbolischen zweiten Richtungspfeil 14) und mit einer Stromstärke von 3500 A.

Wegen des ersten Stromflusses und des zweiten Stromflusses ist in dem Magnetkern 1, in dem Sammelschienenleiter 8, in dem Innenraum 7 sowie in dem Magnetfeldsensor 2 ein magnetisches Feld bzw. ein magnetischer Fluss ausgebildet, welches bzw. welcher mittels einer ersten Flusslinie 15 sowie weiteren Flusslinien symbolisch dargestellt ist. Der Magnetfeldsensor 2 ist demnach in dem magnetischen Fluss angeordnet.

Der Magnetfeldsensor 2 weist einen Messbereich von 0 bis 200 mT auf. Der Messbereich hängt von dem Abstand a und Dimensionen des Magnetkerns 1 (beispielsweise Breite b und Höhe h) ab.

Aufgrund des Abstands a wird eine Abschwächung des magnetischen Felds in dem Magnetkern 1 bewirkt.

Durch die Abschwächung des magnetischen Felds wird eine Reduktion einer Flussdichte in der Stromsensoranordnung erzielt.

Die maximale Flussdichte in dem Magnetkern 1 beträgt 300 mT und liegt weit unter einer Sättigungsflussdichte des Magnetkerns 1 von 700 mT. Eine Sättigung des Magnetkerns 1 wird folglich vermieden.

Die Flussdichte beträgt im Bereich des Magnetfeldsensors 2 117 mT (mittels des Magnetfeldsensors 2 gemessene Flussdichte). Über einen aus dem Stand der Technik bekannten, annähernd linearen Zusammenhang zwischen dieser Flussdichte und der Stromstärke in dem Sammelschienenleiter 8 wird mittels einer nicht gezeigten Auswerteeinheit, welche mit dem Magnetfeldsensor 2 verbunden ist, die Stromstärke in dem Sammelschienenleiter 8 bestimmt. Überschreitet diese Stromstärke einen definierten Schwellwert, so wird dies als Fehler erkannt. Auf Grundlage dessen werden Fehlerströme, wobei es sich beispielsweise um Kurzschlussströme oder Überströme handeln kann, detektiert.

### Liste der Bezeichnungen

- 1: Magnetkern
- 2: Magnetfeldsensor
- 3: Gehäuse
- 4: Zuleiter
- 5: Ableiter
- 6: Distanzstück
- 7: Innenraum
- 8: Sammelschienenleiter
- 9: Erste Seitenwand
- 10: Zweite Seitenwand
- 11: Erste Seitenebene
- 12: Zweite Seitenebene
- 13: Erster Richtungspfeil
- 14: Zweiter Richtungspfeil
- 15: Erste Flusslinie

- a: Abstand
- d: Distanz
- b: Breite
- h: Höhe

## Patentansprüche

1. Stromsensoranordnung mit einem Magnetkern und einem Magnetfeldsensor, die in einem Gehäuse angeordnet sind,
**dadurch gekennzeichnet, dass** ein Zuleiter (4) und ein Ableiter (5) angeordnet sind,
dass der Zuleiter (4) und der Ableiter (5) mit dem Gehäuse (3) verbunden sind,
dass zwischen dem Zuleiter (4) und dem Ableiter (5) ein isolierendes Distanzstück (6) angeordnet ist,
dass der Magnetkern (1) einen Innenraum (7) aufweist, wobei zur Erzielung einer vorteilhaften Schirmung und somit einer hohen Messgenauigkeit der Zuleiter (4) und der Ableiter (5) durch den Innenraum (7) geführt sind und der Magnetfeldsensor (2) in dem Innenraum (7) des Magnetkerns (1) angeordnet ist, und
dass der Zuleiter (4) und der Ableiter (5) in einem definierten Abstand a zueinander angeordnet sind.

2. Stromsensoranordnung nach Anspruch 1, **dadurch gekennzeichnet, dass** der Magnetfeldsensor (2) zwischen dem Zuleiter (4) und dem Ableiter (5) einerseits und dem Magnetkern (1) andererseits auf jener Seite mit einer Distanz d zwischen dem Zuleiter (4) und dem Ableiter (5) einerseits und dem Magnetkern (1) andererseits angeordnet ist.

3. Stromsensoranordnung nach Anspruch 1 oder 2, **dadurch gekennzeichnet, dass** der Magnetkern (1) magnetisch geschlossen ist.

4. Stromsensoranordnung nach einem der Ansprüche 1 bis 3, **dadurch gekennzeichnet, dass** der Magnetfeldsensor (2) als Hall-Sensor ausgebildet ist.

5. Stromsensoranordnung nach einem der Ansprüche 1 bis 3, **dadurch gekennzeichnet, dass** der Magnetfeldsensor (2) als Förster-Sonde ausgebildet ist.

6. Trennschalter mit einer Stromsensoranordnung nach einem der Ansprüche 1 bis 5.

## Claims

1. Current sensor arrangement with a magnetic core and a magnetic field sensor, which are arranged in a housing,
**characterised in that** a conductor (4) and an arrester (5) are arranged,
that the conductor (4) and the arrester (5) are connected to the housing (3),
that an insulating spacer (6) is arranged between the conductor (4) and the arrester (5),
that the magnetic core (1) has an interior space (7), wherein, for the purpose of achieving an advantageous shielding and
thus high measurement accuracy, the conductor (4) and arrester (5) are fed through the interior space (7) and the magnetic field sensor (2) is arranged in the interior space (7) of the magnetic core (1), and
that the conductor (4) and the arrester (5) are arranged at a defined distance a from one another.

2. Current sensor arrangement according to claim 1, **characterised in that** the magnetic field sensor (2) is arranged between the conductor (4) and the arrester (5) on one side and the magnetic core (1) on the other side, with a distance d arranged on either side between the conductor (4) and the arrester (5) on one side and the magnetic core (1) on the other side.

3. Current sensor arrangement according to claim 1 or 2, **characterised in that** the magnetic core (1) is magnetically closed.

4. Current sensor arrangement according to one of claims 1 to 3, **characterised in that** the magnetic field sensor (2) is designed as a Hall sensor.

5. Current sensor arrangement according to one of claims 1 to 3, **characterised in that** the magnetic field sensor (2) is designed as a fluxgate magnetometer.

6. Circuit breaker with a current sensor arrangement according to one of claims 1 to 5.

## Revendications

1. Système de détection de courant comprenant un noyau magnétique et un capteur de champ magnétique disposés dans un boîtier, **caractérisé en ce qu'**un conducteur d'alimentation (4) et un conducteur de déviation (5) sont disposés, **en ce que** le conducteur d'alimentation (4) et le conducteur de déviation (5) sont reliés au boîtier (3), **en ce qu'**une pièce d'écartement isolante (6) est disposée entre le conducteur d'alimentation (4) et le conducteur de déviation (5), **en ce que** le noyau magnétique (1) présente un espace intérieur (7), dans lequel, afin d'obtenir un blindage avantageux et donc une précision de mesure élevée, le conducteur d'alimentation (4) et le conducteur de déviation (5) sont guidés à travers l'espace intérieur (7) et le capteur de champ magnétique (2) est disposé dans l'espace intérieur (7) du noyau magnétique (1), et **en ce que** le conducteur d'alimentation (4) et le conducteur de déviation (5) sont disposés l'un par rapport à l'autre à une distance définie a.

2. Système de détection de courant selon la revendication 1, **caractérisé en ce que** le capteur de champ magnétique (2) est disposé entre le conducteur d'alimentation (4) et le conducteur de déviation (5) d'une part et le noyau magnétique (1) d'autre part, sur le côté présentant une distance d entre le conducteur d'alimentation (4) et le conducteur de déviation (5) d'une part, et le noyau magnétique (1) d'autre part.

3. Système de détection de courant selon la revendication 1 ou 2, **caractérisé en ce que** le noyau magnétique (1) est magnétiquement fermé.

4. Système de détection de courant selon l'une des revendications 1 à 3, **caractérisé en ce que** le capteur de champ magnétique (2) est conçu comme un capteur à effet Hall.

5. Système de détection de courant, selon l'une des revendications 1 à 3, **caractérisé en ce que** le capteur de champ magnétique (2) est conçu comme une sonde Förster.

6. Disjoncteur avec un système de détection de courant selon l'une des revendications 1 à 5.
